# EUROPÄISCHE PATENTSCHRIFT

(11) **EP 2 478 556 B1**
(45) Veröffentlichungstag und Bekanntmachung des Hinweises auf die Patenterteilung: **25.03.2020**
(21) Anmeldenummer: 10757060.8
(22) Anmeldetag: 15.09.2010
(51) Int. Cl.: H01L 23/495, H01L 25/07

(54) **ELEKTRONISCHE VORRICHTUNG ZUM SCHALTEN VON STRÖMEN**
ELECTRONIC DEVICE FOR SWITCHING CURRENTS
DISPOSITIF ÉLECTRONIQUE POUR LA COMMUTATION DE COURANTS

(30) Priorität: 15.09.2009 DE 102009029476
(43) Veröffentlichungstag der Anmeldung: 25.07.2012
(73) Patentinhaber: Lisa Dräxlmaier GmbH, 84137 Vilsbiburg (DE)
(72) Erfinder: WORTBERG, Michael, 84405 Dorfen (DE); HAUSPERGER, Christian, 84155 Bonbruck (DE); AUER, Marcus, Josef, A-5026 Salzburg-Aigen (AT)
(86) Internationale Anmeldenummer: PCT/EP2010/063522
(87) Internationale Veröffentlichungsnummer: WO 2011/032966

(56) Entgegenhaltungen:
- JP-A- 2006 262 664
- JP-A- 2008 206 363
- US-B2- 7 099 155

## Beschreibung

### Gebiet der Erfindung

Die vorliegende Erfindung betrifft eine elektronische Vorrichtung zum Schalten von Strömen und insbesondere eine elektronische Vorrichtung, die zur Verwendung in einem Fahrzeug ausgebildet ist.

### Stand der Technik

Herkömmlich fließen in elektrischen Leitungen, z.B. in einem Automobil, Ströme mit bis zu 1000 Ampere, beispielsweise beim Anlassen eines Verbrennungsmotors durch einen elektrischen Anlassermotor. Hohe Ströme von bis zu 1000 Ampere kommen im Allgemeinen nur kurzzeitig als Stromspitzen vor. Jedoch sind länger fließende Ströme im Bereich von 30 Ampere keine Seltenheit. Für das Schalten solcher Lastströme werden herkömmlich elektromagnetische Relais verwendet.
Neuerdings werden diese elektromagnetischen Relais vermehrt durch Leistungshalbleiter ersetzt, was zu neuen technischen Herausforderung hinsichtlich des Aufbaus und der Verbindungstechnik zur Verwendung der Leistungshalbleiter in Stromverteilern führt.
Es ist bekannt, gehauste Halbleiter als SMD(Surface Mounted Device)- Komponenten auf eine Leiterplatte zu löten. Dabei werden zur Fertigung SMD/THT (Through Hole Technology) Standardprozesse verwendet. Jedoch ist der Bauraumbedarf für gehauste Halbleiter groß. Ferner ist die thermische Zyklenfestigkeit der Halbleiter eingeschränkt und im Halbleiter entstehende Wärme muss über die Leiterplatte oder Platine abgeleitet werden. Trotz der Verwendung von Thermal Vias oder Inlays ist solch eine Anordnung mit hinreichender Zuverlässigkeit nur für Bauräume mit einer Temperatur bis zu 85°C geeignet.
Andererseits wurde vorgeschlagen nackte Halbleiter, sogenannte Bare-Die Halbleiter, auf ein Keramiksubstrat zu löten und zu bonden. Kontakte und/oder Stromschienen werden mit Kunststoff umspritzt und in einem Gehäuse gehalten. Eine Verbindung zwischen einem Stanzgitter, das als Stromverteiler verwendet werden kann, und der Leiterplatte erfolgt beispielsweise durch Bonddrähte. Zur Ableitung von Wärme ist dabei ein großer Kühlkörper unter dem Substrat vorgesehen, der mehrere säulenartige Vorsprünge besitzt, um dessen Oberfläche zu vergrößern. Dadurch lässt sich eine hohe thermische Zyklisierung des nackten Halbleiters erreichen.
Jedoch benötigt der Kühlkörper viel Platz und muss von der Umgebungsluft hinreichend gekühlt werden. Dies führt zu einer großen Vorrichtung, die über mehrere aufwendige und teure Bondverbindungen mit der Ansteuerelektronik und verschiedenen Stromleitungen, die den Laststrom führen, verbunden werden. Die Kühlung des Kühlkörpers mit Umgebungsluft stellt insbesondere im Motorraum von Fahrzeugen aufgrund der dort herrschenden hohen Temperaturen ein Problem dar. Aus der US7,099,155B2 ist eine elektronische Vorrichtung zum Schalten von Strömen bekannt, mit zumindest einigen der genannten Nachteilen.

### Zusammenfassung der Erfindung

Der Erfindung liegt die Aufgabe zugrunde, eine zuverlässige und langlebige elektronische Vorrichtung zum Schalten von Strömen bereitzustellen.

Diese Aufgabe wird durch eine elektronische Vorrichtung mit den Merkmalen des Anspruchs 1 gelöst. Vorteilhafte Ausführungsformen sind in den Unteransprüchen beschrieben.
Gemäß einer Ausführungsform umfasst die elektronische Vorrichtung zum Schalten von Strömen, insbesondere in einem Fahrzeug, einen Leistungshalbleiter, der ansteuerbar ist zum Schalten zwischen mindestens zwei Zuständen; ein Substrat mit zu dem Leistungshalbleiter kompatiblen thermomechanischen Eigenschaften, auf dem der Leistungshalbleiter auf einer Seite angeordnet ist; und eine Stromschiene, die auf der anderen Seite des Substrats angeordnet ist, zum Leiten eines Stroms, wobei das Substrat und die Stromschiene derart miteinander gekoppelt sind, dass eine wärmeleitende Verbindung bereitgestellt wird, so dass Wärme von dem Leistungshalbleiter zur Stromschiene abführbar ist.
Somit kann ein Leistungshalbleiter durch Wärmeleitung über eine Stromschiene gekühlt werden, was insbesondere für elektronische Vorrichtungen in Stromverteilergehäusen und/oder in Motorräumen vorteilhaft ist, da dort aufgrund von sehr warmer Luft und geringem Luftfluss eine einfache Luftkühlung nicht möglich ist. Durch Verwenden einer Stromschiene als Stromleitung und Wärmeleitung lässt sich zudem die elektronische Vorrichtung stark verkleinern und Teile, wie z.B. ein extra Kühlkörper, können eingespart werden.

Gemäß der Erfindung enthält das Substrat Keramik. Somit ist eine hohe thermische Zyklisierung des Leistungshalbleiters auf Keramik mit ähnlichem Ausdehnungskoeffizienten wie dem des Leistungshalbleiters möglich. Insbesondere kann ein Leistungshalbleiter zu hohen Temperaturen von circa 170°C zyklisiert werden, wodurch sich ein gutes thermisches Gefälle in der Stromschiene ergibt.

Gemäß der Erfindung sind das Substrat und die Stromschiene miteinander über eine wärmeleitende Schicht gekoppelt. Somit lässt sich die Wärme leicht und effizient über die so optimierte wärmeleitende Verbindung ableiten. Bevorzugt umfasst die wärmeleitende Schicht einen thermisch leitenden Kleber, eine Wärmeleitpaste oder ein Silikon enthaltendes Pad.
Die Stromschiene ist mit dem Leitungshalbleiter entweder direkt oder indirekt elektrisch verbunden. Bei einer indirekten Verbindung ist beispielsweise der Leistungshalbleiter mit einer Leiterplatte verbunden und diese ist wiederum mit der Stromschiene verbunden.

Gemäß einer weiteren vorteilhaften Ausführungsform umfasst die elektronische Vorrichtung eine Leiterplatte, wobei das Substrat und der Leistungshalbleiter ein Leistungsmodul bilden, das mit der Leiterplatte elektrisch verbunden ist. Somit können verschiedene Schaltungen auf der Leiterplatte, die beispielsweise als Strombrücke dient, gemäß herkömmlichen Prozessen gebildet werden, wodurch der Aufbau der elektronischen Vorrichtung vereinfacht und standardisiert wird. Bevorzugt ist die Stromschiene zwischen der Leiterplatte und dem Substrat angeordnet.
Gemäß einer weiteren vorteilhaften Ausführungsform weist die Leiterplatte Anschlusskontakte zur elektrischen Verbindung mit dem Leistungsmodul über Anschlussleitungen auf. Somit können durch standardisierte Lötprozesse das Leistungsmodul und die Leiterplatte miteinander elektrisch verbunden werden.
Gemäß einer weiteren vorteilhaften Ausführungsform umfasst die elektronische Vorrichtung eine Messeinrichtung zum Messen des Spannungsabfalls über mindestens eine der Anschlussleitungen. Beispielsweise kann der Spannungsabfall über eine Anschlussleitung als Messgröße für die Messung des Stroms dienen, der durch die Vorrichtung getragen wird. Dafür misst der Mikrokontroller auf der Leiterplatte den Spannungsabfall über die beispielsweise als Lead Frame Pins ausgeprägten Anschlussleitungen und ermittelt den zum Spannungsabfall proportionalen Strom.

Gemäß einer weiteren vorteilhaften Ausführungsform ist die Stromschiene über Anschlussleitungen, z.B. Lötfahnen, mit der Leiterplatte elektrisch verbunden. Somit dient die Stromschiene zur Stromversorgung der Leiterplatte, die wiederum mit dem Leistungsmodul elektrisch verbunden ist.

Gemäß einer vorteilhaften Ausführungsform werden zwei Stromschienen bereitgestellt, wobei die weitere Stromschiene auf der einen Seite des Substrats angeordnet ist, und das Substrat und die weitere Stromschiene derart miteinander gekoppelt sind, dass eine wärmeleitende Verbindung bereitgestellt wird, so dass Wärme von dem Leistungshalbleiter zur weiteren Stromschiene abführbar ist. Somit kann Wärme noch effektiver abgeführt werden.

Gemäß einer weiteren vorteilhaften Ausführungsform werden zwei Stromschienen bereitgestellt, wobei die weitere Stromschiene neben der ersten Stromschiene auf der anderen Seite des Substrats angeordnet ist. Somit kann Wärme noch effektiver abgeführt werden. Insbesondere sind die erste Stromschiene und die zweite (weitere) Stromschiene jeweils an der der anderen Stromschiene zugewandten Seite mit der Leiterplatte über Anschlussleitungen verbunden, und die Stromführung ist derart ausgebildet, dass eine der Stromschienen als stromzuführende Stromschiene dient und die andere als stromabführende Stromschiene dient. Somit dienen zwei Stromschienen nicht nur zur Wärmeleitung, sondern auch als Teil eines Stromkreises.

In einer weiteren vorteilhaften Ausführungsform umfasst die elektronische Vorrichtung eine auf der Leiterplatte angeordnete Ansteuerlogik. Somit sind der Leistungshalbleiter und die Ansteuerlogik getrennt, wodurch auch ein Ansteuerstromkreis und ein Laststromkreis getrennt werden können.

Weitere vorteilhafte Merkmale der Erfindung werden in der detaillierten Beschreibung der Ausführungsformen und in den Ansprüchen offenbart.

### Kurze Beschreibung der Zeichnungen

Im Folgenden wird die Erfindung ausführlich anhand der beigefügten Zeichnungen beschrieben, die Folgendes zeigen.
Fig. 1 zeigt schematisch eine elektronische Vorrichtung gemäß einer Ausführungsform.
Fig. 2 zeigt ein Flussdiagramm, das die Schritte eines Herstellungsverfahrens zum Herstellen einer elektronischen Vorrichtung gemäß einer weiteren Ausführungsform zeigt.
Fig. 3 zeigt eine Draufsicht und Seitenansicht eines Leistungsmoduls.
Fig. 4 zeigt eine Leiterplatte, die ein Teil der elektronischen Vorrichtung gemäß einer weiteren Ausführungsform bildet.
Fig. 5 zeigt wie Stromschienen auf der Leiterplatte angeordnet sind.
Fig. 6 zeigt eine Seitenansicht einer Stromschiene.
Fig. 7 zeigt Stromschienen auf einer Leiterplatte, wobei eine der Stromschienen eine wärmeleitende Schicht aufweist.
Fig. 8 zeigt eine elektronische Vorrichtung gemäß einer weiteren Ausführungsform.
Fig. 9 zeigt eine Seitenansicht der elektronischen Vorrichtung von Fig. 8.
Figs. 10A, 10B und 10C zeigen eine Draufsicht, Seitenansicht und 90° gedrehte Seitenansicht einer elektronischen Vorrichtung gemäß einer weiteren Ausführungsform.
Fig. 11 zeigt ein Beispiel einer Stromschiene mit Lötfahnen.
Figs. 12A und 12B zeigen eine elektronische Vorrichtung gemäß einer weiteren Ausführungsform.
Figs. 13 und 14 zeigen eine andere elektronische Vorrichtung in Draufsicht bzw. Seitenansicht gemäß einer weiteren Ausführungsform.

### Beschreibung der Ausführungsformen

Bevorzugte Ausführungsformen der vorliegenden Erfindung werden nachfolgend ausführlich unter Bezugnahme auf die begleitenden Zeichnungen beschrieben. Dabei sind in den verschiedenen Zeichnungen gleiche oder entsprechende Elemente jeweils mit den gleichen oder ähnlichen Bezugszeichen bezeichnet.

Die bevorzugten Ausführungsformen der Erfindung, die im Folgenden detailliert beschrieben werden, werden ausführlich mit Bezug auf eine elektronische Vorrichtung zum Schalten von Strömen, insbesondere in einem Bordnetz eines Fahrzeugs, beschrieben. Jedoch wird vermerkt, dass die folgende Beschreibung nur Beispiele enthält und nicht als die Erfindung einschränkend angesehen werden sollte.

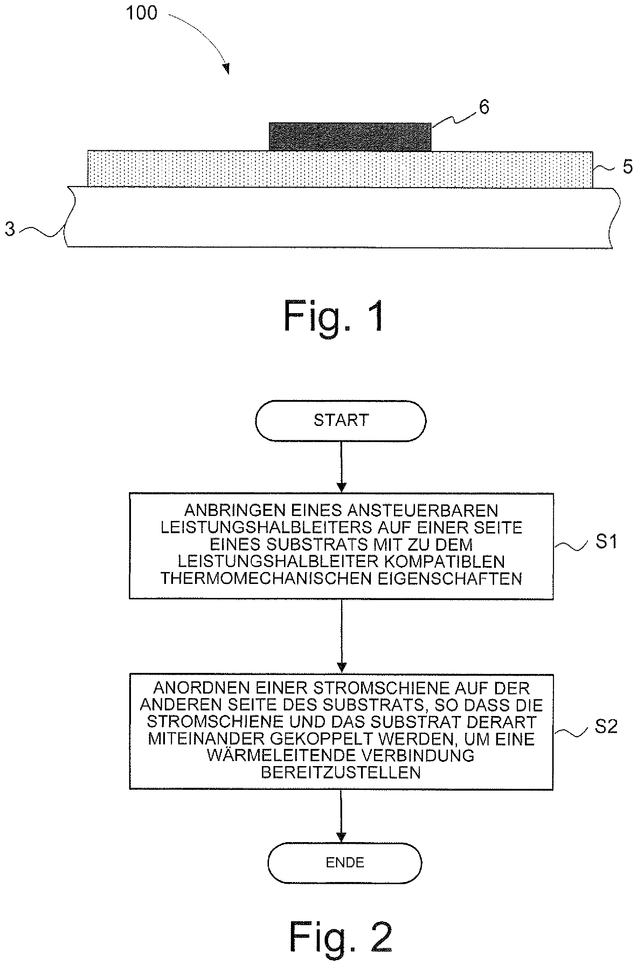

Fig. 1 zeigt schematisch Elemente einer elektronischen Vorrichtung zum Schalten von Strömen, insbesondere Lastströmen, und kann beispielsweise in einem Fahrzeug verwendet werden. Die elektronische Vorrichtung 100 in Fig. 1 umfasst einen Leistungshalbleiter 6, ein Substrat 5 und eine Stromschiene 3.

Der Leistungshalbleiter 6 ist beispielsweise ein nackter Halbleiter und kann auf das Substrat 5 gelötet und/oder gebondet werden.

Der Leistungshalbleiter 6 ist ansteuerbar, beispielsweise von einer später beschriebenen Ansteuerlogik, um zwischen mindestens zwei Zuständen zu schalten. Beispielsweise ist der Leistungshalbleiter 6 als einfacher Schalter ausgebildet und schließt oder öffnet einen Stromkreis. Dabei können hohe Lastströme, beispielsweise bei der Verwendung in einem Fahrzeug, auftreten, was zu einer starken Erhöhung der Temperatur in dem Leistungshalbleiter führen kann.

Der Leistungshalbleiter oder Lastschalter kann beispielsweise als Leistungs-MOSFET realisiert werden, wie in der Patentanmeldung DE 10 2007 062 955 beschrieben. Bei hohen Lastströmen bietet sich eine Parallelschaltung aus mehreren Leistungs-MOSFETs an, so dass nur Teile des Laststroms über jeweils einen Leistungs-MOSFET fließen. Natürlich können auch andere Feldeffekt-Transistoren verwendet werden anstatt von Metalloxyd-Halbleiter-Feldeffekt-Transistoren (MOSFETs), die über niedrige Gate-Spannungen mit minimaler Verzögerung schaltbar sind.

Die durch die hohen Ströme entstehenden hohen Temperaturen können zu thermisch induzierten Verspannungen führen, d.h. der Leistungshalbleiter kann sich ausdehnen. Deshalb wird ein Substrat 5 mit zu dem Leistungshalbleiter 6 kompatiblen thermomechanischen Eigenschaften bereitgestellt. Der Leistungshalbleiter 6 ist, wie in Fig. 1 gezeigt, auf der oberen Seite des Substrats angeordnet. Beispielsweise kann der Leistungshalbleiter 6 durch Löten und Bonden auf dem Substrat 5 befestigt werden. Da das Substrat kompatible thermomechanische Eigenschaften zu dem Leistungshalbleiter aufweist, d.h. sich bei Temperaturerhöhung (oder Temperaturverringerung) ähnlich hinsichtlich einer Formveränderung verhält wie der Leistungshalbleiter 6, kann eine Beschädigung des Leistungshalbleiters 6 aufgrund einer unterschiedlichen Wärmeausdehnung des Substrats und des Halbleiters vermieden werden.

Erfindungsgemäß wird als Substrat ein Metall-Keramik-Substrat, wobei das Substrat einen ähnlichen oder einen entsprechenden Ausdehnungskoeffizienten bzw. Wärmeausdehnungskoeffizienten wie der Leistungshalbleiter besitzt. Beispielsweise können die Ausdehnungskoeffizienten um circa 20% unterschiedlich sein, und eine Beschädigung des Leistungshalbleiters 6 aufgrund verschiedener thermomechanischer Eigenschaften wird so noch immer größtenteils vermieden. Da Keramik ein nichtoptimaler Wärmeleiter ist, wird bevorzugt eine dünne Schicht von 0,3 bis 1mm Dicke, vorzugsweise 0,63mm, als Substrat verwendet,

Wie in Fig. 1 gezeigt, ist die Stromschiene 3 auf der unteren Seite des Substrats 5 angeordnet. Die Stromschiene 3 dient zum Zuführen oder Abführen eines Laststroms und kann daher einen Teil eines Stromkreises bilden. Die Stromschiene 3 kann auch Teil eines Stanzgitters sein oder ein Teil eines Stromverteilersystems in einem Fahrzeug. Beispielsweise besteht die Stromschiene 3 aus gestanztem Kupferblech mit einer Dicke von circa 1mm.

Das Substrat 5 und die Stromschiene 3 sind derart miteinander gekoppelt, dass eine wärmeleitende Verbindung bereitgestellt wird, so dass Wärme von dem Leistungshalbleiter 6 zur Stromschiene abführbar ist. Im Einzelnen wird in dem Leistungshalbleiter 6 durch hohe Ströme erzeugte Wärme durch das Substrat 5, großteils durch Wärmeleitung, an die Stromschiene 3 zugeführt, von wo aus die Wärme weiter durch ein Stromverteilersystem abgeführt werden kann. Hierbei bietet es sich an, als Material für die Stromschiene ein Material zu verwenden, das gut elektrisch leitend sowie thermisch leitend ist, wie z.B. Kupfer.

Es wird bemerkt, dass bei einer direkten Anbindung des Leistungshalbleiters an die Stromschiene die unterschiedlichen thermomechanischen Eigenschaften, z.B. Ausdehnungskoeffizient, des Halbleitermaterials und des Stromschienenmaterials dazu führen, dass Risse im Leistungshalbleiter 6 entstehen können. Dies führt zu einer reduzierten thermischen Zyklisierbarkeit, da schon nach einigen Temperaturerhöhungen entweder die Verbindung zwischen Leistungshalbleiter 6 und Substrat 5 sich löst oder der Leistungshalbleiter 6 anderweitig Schaden nimmt.

Zur Verbindung des Leistungshalbleiters 6 und der Stromschiene 3 wären auch duktiles bleihaltiges Lot, was zu Umweltschutzproblemen führen kann, oder teure Molybdän-Lötplättchen notwendig. Bleifreies Lot mit Molybdän-Lötplättchen kann leicht spröde werden, vor allem bei mehreren thermischen Zyklen.

Zudem sollten Stromschienen aufgrund eines Korrosionsschutzes für Automotive-Anwendungen verzinnt sein. Auf einer verzinnten Kontaktseite kann jedoch nicht gebondet werden, so dass aufwändig herzustellende teilverzinnte Stromschienen verwendet werden müssen. Diese Probleme werden durch Zwischenschieben des Substrats 5 umgangen, so dass keine direkte Verbindung zwischen Leistungshalbleiter 6 und Stromschiene 3 vorliegt.

Zum Verbessern der Wärmeleitung zwischen der Stromschiene 3 und dem Substrat 5 kann eine wärmeleitende Schicht zwischen diesen angebracht werden. Die wärmeleitende Schicht umfasst beispielsweise einen thermisch leitenden Kleber, eine Wärmeleistpaste oder ein Silikon enthaltendes Pad. Dies sind nur einige Beispiele für eine wärmeleitende Schicht, und dem Fachmann sind andere Materialien und Schichten bekannt, mit denen ein Substrat, z.B. aus Keramik, und eine Stromschiene, z.B. aus Kupfer, miteinander derart gekoppelt werden können, dass eine gute Wärmeleitfähigkeit bereitgestellt wird.

Ferner ist zu bemerken, dass aufgrund der nichtleitenden Keramik in dem Substrat 5 keine elektrische Leitung über das Substrat 5 zwischen dem Leistungshalbleiter 6 und der Stromschiene 3 bereitgestellt wird. Jedoch können die Stromschiene 3 und der Leistungshalbleiter 6 durch Leiterbahnen in dem Substrat 5 oder anderen elektrisch leitenden Verbindungen auf und/oder neben dem Substrat miteinander verbunden werden.

Fig. 2 zeigt ein Flussdiagramm mit den Schritten eines Herstellungsverfahrens für eine elektronische Vorrichtung gemäß einer weiteren Ausführungsform. Dabei wird in dem ersten Schritt S1 ein ansteuerbarer Leistungshalbleiter auf einer Seite eines Substrats, z.B. Substrat 5, mit zu dem Leistungshalbleiter kompatiblen thermomechanischen Eigenschaften angebracht.

Dann wird in einem zweiten Schritt S2 eine Stromschiene, bevorzugt mit einer wärmeleitenden Schicht, auf der anderen Seite des Substrats angeordnet, so dass die Stromschiene und das Substrat derart miteinander gekoppelt werden, dass eine wärmeleitende Verbindung bereitgestellt wird.

Somit kann durch wenige einfache Schritte eine elektronische Vorrichtung, wie die in Fig. 1 gezeigte, hergestellt werden. Speziellere elektronische Vorrichtungen, die im Folgenden beschrieben werden, können durch Hinzufügung weiterer Herstellungsschritte durch Erweiterung der hier beschriebenen elektronischen Vorrichtung auch hergestellt werden. Beispielsweise kann eine Leiterplatte bereitgestellt werden mit Durchkontaktierungen, die einfach mit der Stromschiene und dem Substrat unter dem Leistungshalbleiter verbunden werden kann.

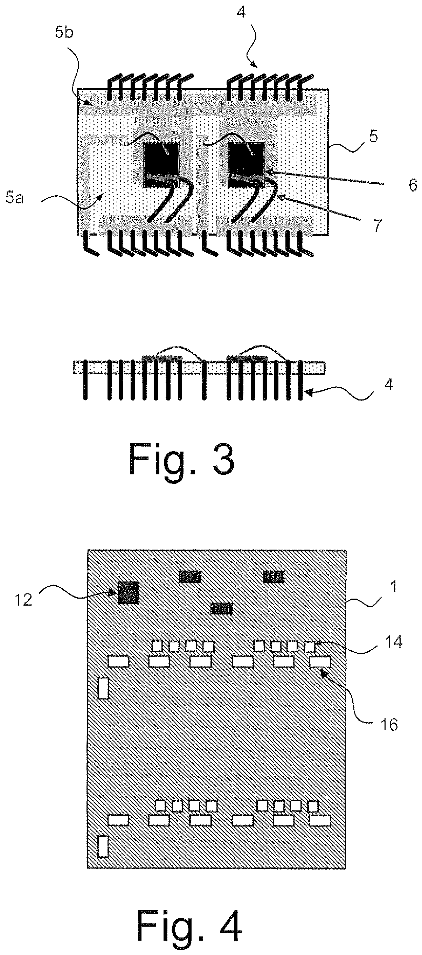

Fig. 3 zeigt in einer Draufsicht und einer Seitenansicht ein Beispiel wie ein Leistungshalbleiter 6 auf dem Substrat 5 angeordnet werden kann, wobei auch Anschlussleitungen 4 und 7 gezeigt sind. Die Kombination aus Substrat und Leistungshalbleiter wird im Folgenden Leistungsmodul genannt, wobei das in Fig. 3 gezeigte Leistungsmodul zwei Leistungshalbleiter aufweist.

In der Draufsicht in Fig. 3 ist das Substrat 5 als nichtleitendes, beispielsweise Keramik, Substrat 5a ausgebildet und weist Leiterbahnen 5b auf. Die Leiterbahnen 5b (grau) sind mit elektrischen Anschlussleitungen 4 und 7 verbunden. An den Seiten des Substrats werden in einem Lötprozess Lead Frames mit Lötpins verbunden, so dass die Anschlussleitungen 4 (Anschlussbeinchen) sogenannte Lead-Frame-Pins darstellen, die mit gedruckten Leiterbahnen auf beispielsweise Keramik verbunden werden. Die Leistungshalbleiter 6 sind auf dem Substrat gelötet und gebondet und, wie in Fig. 3 gezeigt, die Anschlussleitungen 7 zwischen Leistungshalbleiter 6 und einer Leiterbahn 5b auf dem Substrat sind als Bonddrähte ausgebildet.

Im Folgenden wird eine Leiterplatte, die zur Verwendung mit dem oben beschriebenen Leistungshalbleiter, Substrat und der Stromschiene ausgebildet ist, mit Bezug auf Fig. 4 im Einzelnen beschrieben.

Die Leiterplatte 1 von Fig. 4 kann bei einer im Folgenden beschriebenen elektronischen Vorrichtung als Basisplatine verwendet werden. Beispielsweise kann eine Ansteuerlogik 12 auf der Leiterplatte 1 angeordnet werden. Die Ansteuerlogik 12 kann einen Mikrocontroller oder andere Art von Steuerchip umfassen und dient zum Ansteuern von Leistungshalbleitern, so dass der Schaltzustand eines Leistungshalbleiters durch die Ansteuerlogik 12 gewählt werden kann. Somit ist auch eine Auftrennung von Lastströmen und Steuerströmen möglich, wobei die Steuerströme über die Ansteuerlogik fließen und die Lastströme über die oben beschriebene Stromschiene und den Leistungshalbleiter.

Des Weiteren weist die Leiterplatte 1 in Fig. 4 mehrere Anschlusskontakte 14 und 16 auf. Die Anschlusskontakte 14 sind für Anschlussleitungen an das oben beschriebene Leistungsmodul vorgesehen. Die Anschlusskontakte 16 sind für Anschlussleitungen an die oben beschrieben Stromschiene vorgesehen. Die Anschlusskontakte können als Durchkontaktierungen ausgebildet sein, so dass ein einfaches Anschließen der Anschlussleitungen möglich ist. Jedoch können die Anschlusskontakte auch Anschlussfelder darstellen auf die die Anschlussleitungen beispielsweise gelötet werden. Wie im Folgenden beschrieben wird, kann eine Stromschiene Lötfahnen als Anschlussleitungen aufweisen, die mit den Anschlusskontakten 16 verbunden werden.

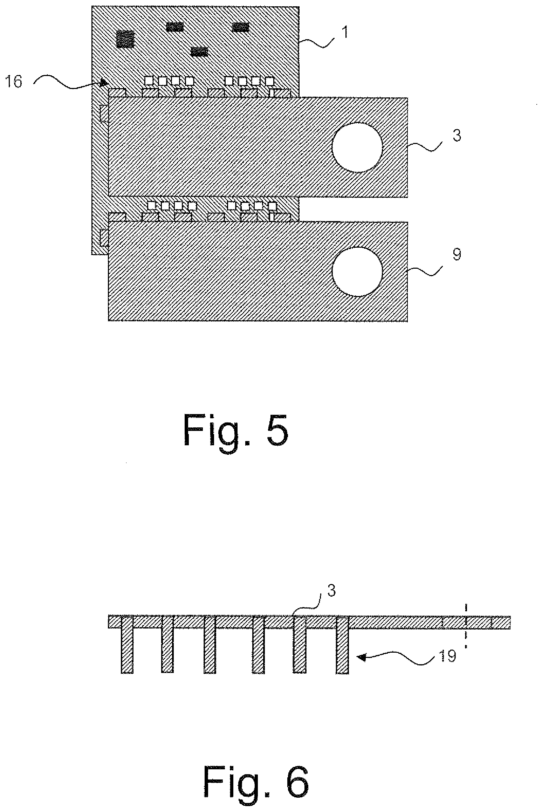

Fig. 5 zeigt eine Draufsicht, bei der zwei Stromschienen 3 und 9 auf der Leiterplatte 1 angeordnet sind. Wie mit Bezug auf Fig. 4 beschrieben, kontaktieren in Fig. 6 dargestellte Anschlussleitungen 19, beispielsweise Lötfahnen, der Stromschiene 3 und 9 die Anschlusskontakte 16. Hier kann beispielsweise die Stromschiene 3 als stromzuführende Stromschiene verwendet werden und die Stromschiene 9 als stromabführende Stromschiene.

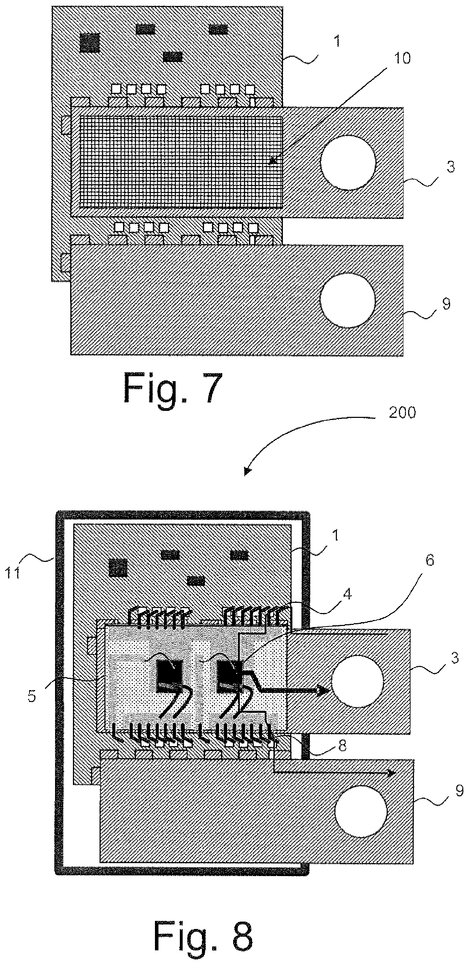

In Fig. 7 sind die gleiche Leiterplatte 1 und Stromschienen 3 und 9, wie in Fig. 5 gezeigt, dargestellt. Zusätzlich ist auf der Stromschiene 3 eine wärmeleitende Schicht 10 vorgesehen, die ein sogenanntes thermisches Interface darstellt, um die thermische Anbindung eines Leistungsmoduls, wie das in Fig. 3 beschriebene, an eine Stromschiene zu verbessern. Wie bereits mit Bezug auf Fig. 1 ausgeführt, kann die wärmeleitende Schicht 10 einen thermisch leitenden Kleber, eine Wärmeleitpaste oder ein Silikon enthaltendes Pad umfassen.

Im Folgenden wird eine elektronische Vorrichtung mit Leiterplatte gemäß einer Ausführungsform mit Bezug auf Fig. 8 beschrieben.

In Fig. 8 ist das in Fig. 3 beschriebene Leistungsmodul, das das Substrat 5 und den Leistungshalbleiter 6 umfasst, auf der Stromschiene 3 von Fig. 5 (ohne wärmeleitende Schicht) oder von Fig. 7 (mit wärmeleitender Schicht) angeordnet. Das Leistungsmodul kann beispielsweise wie ein Through-Hole-Bauteil aufgesetzt werden. In einem Lötwellenprozess werden die Leiterplatte 1, die Stromschiene 3 und das Leistungsmodul miteinander verbunden und können danach in einem Gehäuse 11, vorzugsweise aus Kunststoff, montiert oder umspritzt werden.

Ein Stromfluss (dünner Pfeil) und eine Wärmefluss (dicker Pfeil) in der elektronischen Vorrichtung 200 ist auch in Fig. 8 gezeigt. Im Einzelnen geht im durchgeschalteten Zustand des in Fig. 8 gezeigten Leistungshalbleiters 6 der Strom über die Stromschiene 3, d.h. Strom wird über die Stromschiene 3 in die elektronische Vorrichtung 200 eingespeist. Danach fließt der Strom über mindestens eine Lötfahne der Stromschiene 3 auf die Leiterplatte 1. Von dort fließt der Strom nur ein kurzes Stück über die Leiterplatte 1 und dann über die Anschlussleitungen 4 des in Fig. 3 gezeigten Leistungsmoduls auf die Metallisierung (z.B. Leiterbahn) des Substrats (s. dünner Pfeil).

Die Ableitung des Stroms erfolgt über die Anschlussleitungen auf der Source-Seite des Leistungshalbleiters über die Leiterplatte 1 und die Lötfahnen der Stromschiene 9. Insbesondere fließt der Strom, wie in Fig. 8 gezeigt, durch die Anschlussleitungen 8 zurück auf die Leiterplatte 1 und von dort über die Lötfahnen der Stromschiene 9 auf die Stromschiene 9. Die Anschlussleitungen des Leistungsmoduls und die Lötfahnen der Stromschiene liegen wie in Fig. 8 gezeigt, nahe bei einander, um eine gute elektrische Anbindung der beiden zu erreichen. Aus Gründen der Übersichtlichkeit sind auf der Leiterplatte 1 keine Leiterbahnen oder eine Leiterstruktur dargestellt.

In der elektronischen Vorrichtung 200 von Fig. 8 erfolgt die thermische Anbindung eines Leistungshalbleiters beispielsweise durch die Keramik und die wärmeleitende Schicht auf die stromzuführende Stromschiene 3 (dicker Pfeil) und von dort in den Leistungssatz oder in Stromschienen eines Verteilers, die wärmeleitend mit der Stromschiene 3 verbunden sind.

Wie in Fig. 8 gezeigt, ist die Stromschiene 3 zwischen der Leiterplatte 1 und dem Substrat 5 angeordnet, so dass die Anschlussleitungen gut zugänglich sind und leicht mit entsprechenden Kontakten verbunden bzw. gelötet werden können. Jedoch ist es auch denkbar, dass die Leiterplatte 1 über dem Leistungsmodul und der Stromschiene 3 angebracht wird, so dass das Leistungsmodul zwischen der Leiterplatte 1 und der Stromschiene 3 liegt.

Ferner kann die elektronische Vorrichtung 200 eine Messeinrichtung aufweisen zum Messen des Spannungsabfalls über mindestens eine der Anschlussleitungen zwischen Leistungsmodul und Leiterplatte, d.h. über einen Lead-Frame-Pin. Dieser Spannungsabfall kann vorteilhafterweise als Messgröße für die Messung des Stroms dienen, der durch die Vorrichtung getragen wird. Dafür misst der Mikrokontroller, der Teil der Ansteuerlogik sein kann, auf der Leiterplatte den Spannungsabfall über die Lead Frame Pins und ermittelt den zum Spannungsabfall proportionalen Strom. Beispielsweise kann solch eine Anschlussleitung (hier als Lead Frame Pin ausgebildet) aus dem Material CuSn6 hergestellt werden. Da dieses einen sehr geringen Temperaturkoeffizienten aufweist (1/6 von Kupfer) ist somit eine von der Temperatur weitgehend unabhängige und daher genaue Strommessung möglich. Somit können eine oder mehrere Anschlussleitungen einen zusätzlichen Mess-Shunt ersetzen.

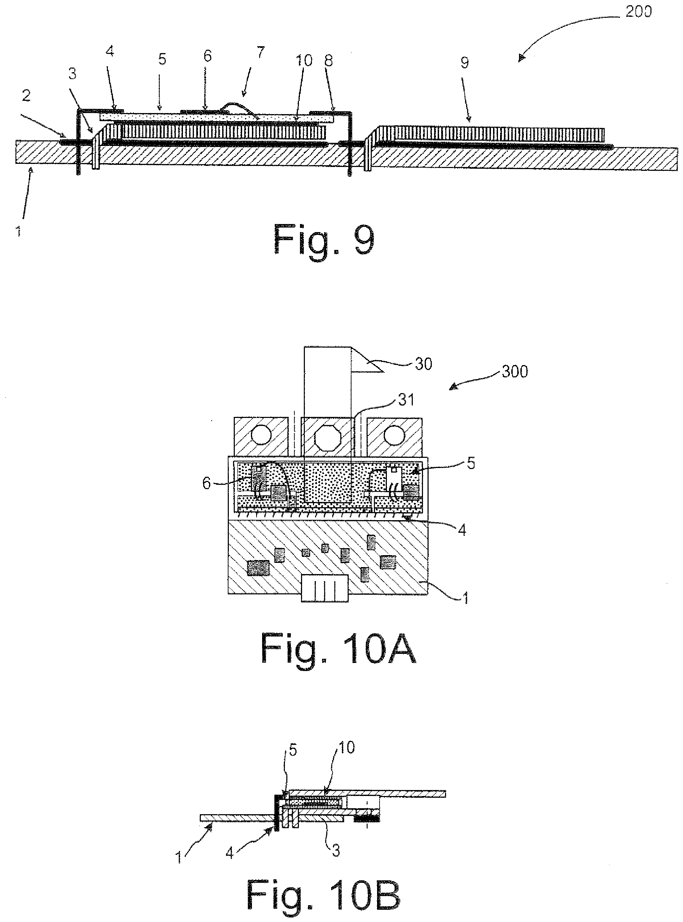

Fig. 9 zeigt eine Seitenansicht der elektronischen Vorrichtung 200, die mit Bezug auf Fig. 8 beschrieben wurde.

In Fig. 9 bezeichnen die gleichen Bezugszeichen die gleichen Elemente wie in Fig. 8. Insbesondere ist eine Leiterplatte 1 dargestellt, die die Ansteuerlogik sowie Leiterbahnen 2 aufweist. Die stromzuführende und wärmeableitende Stromschiene 3 ist zusammen mit einer Lötfahne dargestellt.

Die stromzuführenden Anschlussleitungen 4 sind mit Löt-Pads auf dem Substrat 5 verlötet, wobei das Substrat gedruckte Leiterbahnen aufweisen kann, die in der Seitenansicht nicht dargestellt sind. Der Leistungshalbleiter 6 ist durch einen Bonddraht 7 mit den Leiterbahnen des Substrats 5 verbunden. Die stromabführenden Anschlussleitungen 8 (Lead Frame Pins) sind mit Löt-Pads auf dem Substrat verlötet und auf der anderen Seite mit der Leiterplatte verbunden.

Die wärmeleitende Schicht 10 ist zwischen dem Substrat 5 und der Stromschiene 3 dargestellt. Ferner ist die Stromschiene 9 mit einer Lötfahne auf einer Leiterbahn der Leiterplatte 1 dargestellt, wodurch die Stromschiene 9 elektrisch verbunden ist mit der Anschlussleitung 8.

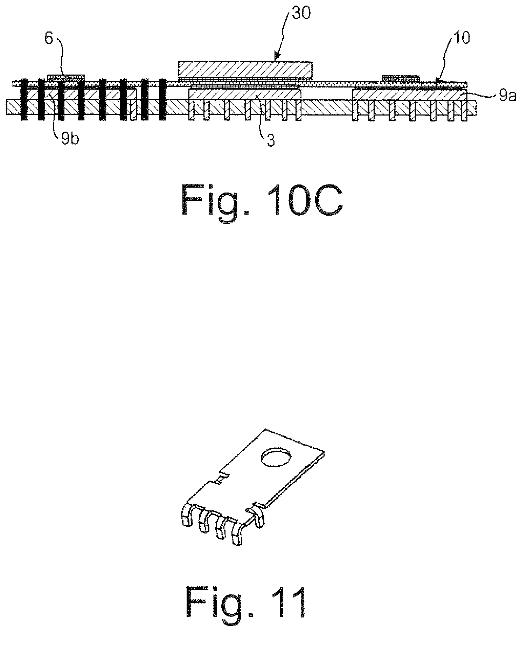

In den Figuren 10A bis 10C ist eine elektronische Vorrichtung einer weiteren Ausführungsform dargestellt. Fig. 10A zeigt eine Draufsicht der elektronischen Vorrichtung 300 und Fig. 10B und 10C zeigen Seitenansichten.

Die elektronische Vorrichtung weist drei Stromschienen 3, 9a und 9b mit Lötfahnen auf, wobei die mittlere Stromschiene 3 der Stromzuführung dient, und der Strom weiter über die Anschlussleitungen 4 auf das Substrat gebracht wird. Die Stromableitung erfolgt über die Stromschienen 9a und 9b. Ein Beispiel einer in der elektronischen Vorrichtung 300 verwendeten Stromschiene ist in Fig. 11 dargestellt.

In dieser speziellen Ausführungsform wird eine zusätzliche externe Stromschiene 30, die als Bügel zu einer Batterie ausgebildet werden kann, auf dem Substrat bereitgestellt und mit einer Schraubverbindung und einem Abstandshalter 31 mit der mittleren Stromschiene 3 verbunden. Diese externe Stromschiene 30 ist derart verlängert, dass sie mittig auf dem Leistungsmodul aufliegt, dieses fixiert und zusätzlich Wärme abführt.

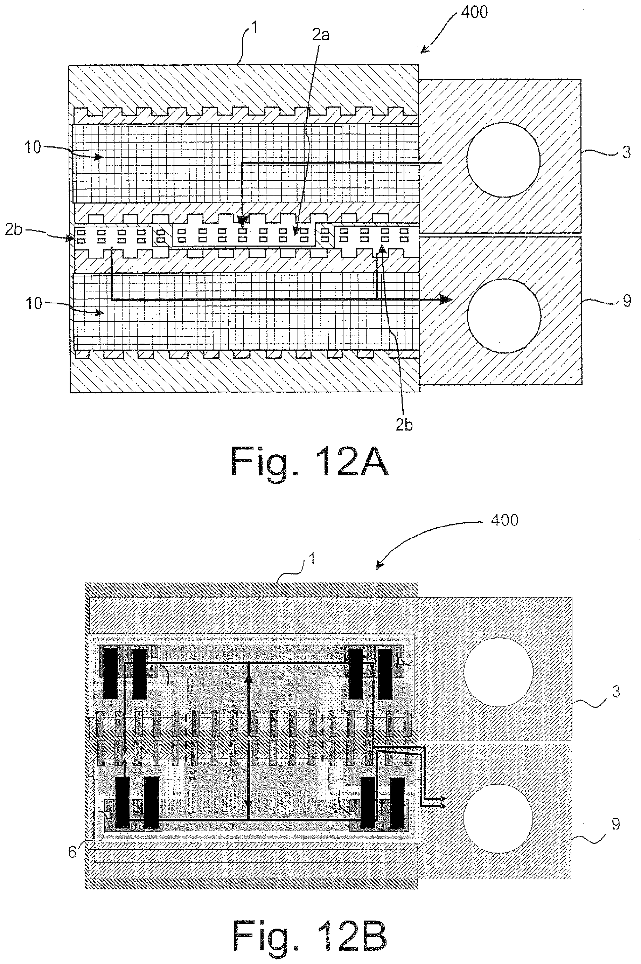

Der Stromfluss erfolgt von der externen Stromschiene 30 zu der Stromschiene 3 und von dort durch die Anschlussleitungen 4 auf das Substrat 5 und über weitere Anschlussleitungen auf die Stromschienen 9a und 9b über die Leiterplatte 1. Der Wärmefluss erfolgt über die wärmeleitende Schicht 10, die zwischen jeder Stromschiene und dem Substrat, wie in Fig. 10C gezeigt, vorhanden ist, so dass die Wärme über die Stromschienen abgeleitet werden kann. Bei der elektronischen Vorrichtung 300, die als Doppelrelais ausgebildet ist, sind die Anschlussleitungen zwischen Substrat und Leiterplatte alle auf einer Seite angeordnet, was die Herstellung vereinfacht und auch später mit Bezug auf Figuren 12A und 12B beschrieben wird.

Fig. 12A und 12B zeigen eine elektronische Vorrichtung gemäß einer spezifischen Ausführungsform. Hier sind wieder die Stromschiene 3 und die Stromschiene 9 gezeigt, wobei die Stromschiene 3 und die Stromschiene 9 jeweils an der der anderen Stromschiene zugewandten Seite mit der Leiterplatte 1 verbunden sind. Daher müssen, wie in Fig. 12A gezeigt, Anschlusskontakte für Anschlussleitungen (Lead frame Pins) an ein oder mehrere Leistungsmodule nur auf einer Seite bereitgestellt werden. Dies vereinfacht den Herstellungsprozess. Ein beispielhafter Stromfluss in den in Fig. 12B dargestellten Leistungsmodulen ist durch die Pfeile in Fig. 12B dargestellt, wobei die Stromschiene 3 die stromzuführende Stromschiene darstellt und die Stromschiene 9 die stromabführende Stromschiene darstellt.

Der Stromfluss von den Stromschienen zu den Leiterbahnen auf der Leiterplatte ist in Fig. 12A durch Pfeile dargestellt und der Stromfluss von den Leiterbahnen auf der Leiterplatte zu den und von den Leistungshalbleitern ist in Fig. 12B durch Pfeile dargestellt.

Im Einzelnen wird, wie in Fig. 12A dargestellt, ein Laststrom von der Stromschiene 3 an die mittlere Leiterbahn 2a zugeführt, von wo Anschlussleitungen den Strom an die zwei dargestellten Substrate mit jeweils zwei Leistungshalbleitern verteilen (Fig. 12B). Dann fließt der Strom zurück über Anschlussleitungen an die Leiterbahnen 2b auf der Leiterplatte, wobei die Leiterbahnen 2b mit der stromabführenden Stromschiene 9 über beispielsweise Lötfahnen verbunden sind, so dass der Strom über die Stromschiene 9 abfließen kann.

Somit erlaubt die in den Fig. 12A und 12B gezeigte Anordnung der elektronischen Vorrichtung 400 eine kompakte und platzsparende Vorrichtung mit vier Leistungshalbleitern, die jeweils ¼ des durch die Stromschiene 3 zugeführten Stroms schalten.

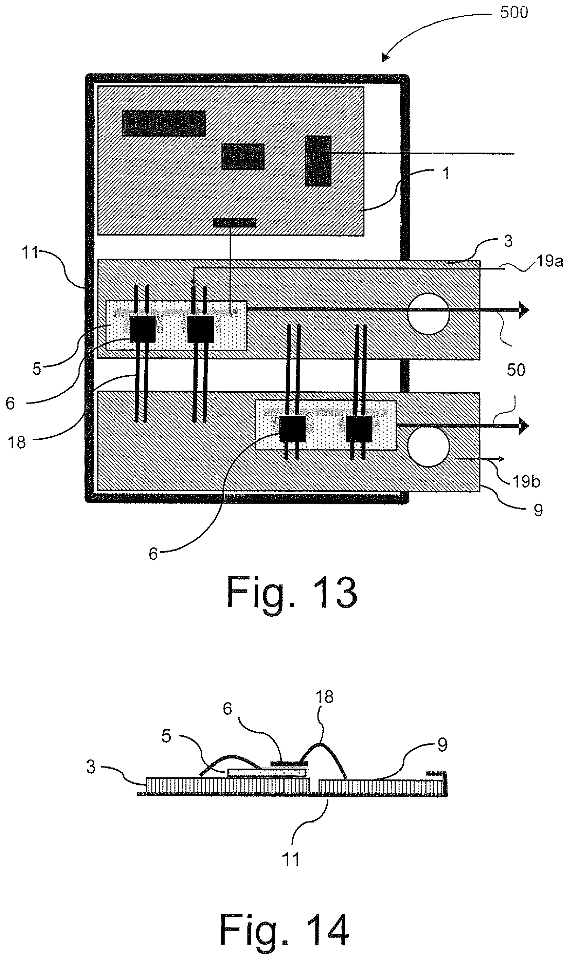

Figuren 13 und 14 zeigen eine elektronische Vorrichtung 500 gemäß einer weiteren spezifischen Ausführungsform. Hier sind wieder die Stromschiene 3 und die Stromschiene 9 gezeigt, wobei die Stromschienen über Leistungsmodule aus mindestens einem Leistungshalbleiter 6 und Substrat 5 miteinander elektrisch verbunden sind.

In Figur 13 ist die Stromschiene 3 als stromzuführende Stromschiene gezeigt (dünner Pfeil 19a) und die weitere Stromschiene 9 als stromabführende Stromschiene gezeigt (dünner Pfeil 19b). Beispielsweise ist die Stromschiene 3 über Anschlussleitungen mit einer Leiterbahn auf dem Substrat 5 verbunden und die Leiterbahn wiederum mit einem Leistungshalbleiter 6 auf dem Substrat 5. Der Leistungshalbleiter 6 der Stromschiene 3 ist wiederum über Anschlussleitungen 18 mit der Stromschiene 9 elektrisch verbunden. Eine Seitenansicht dieser Anordnung ist in Figur 14 gezeigt.

Somit kann durch die in Figur 13 gezeigten Leistungsmodule ein Strom von der Stromschiene 3 zu der Stromschiene 9 unterbrochen bzw. ausgeschaltet werden. In dem in Figur 13 gezeigten Beispiel sind die Leistungshalbleiter 6 auf mehrere Stromschienen verteilt, um die Wärmeabfuhr über die Stromschienen entsprechend zu optimieren, was durch die Pfeile 50 dargestellt ist. Je nach Größe des Stroms ist es auch möglich nur einen Leistungshalbleiter auf der Stromschiene 3 und/oder Stromschiene 9 vorzusehen oder mehrere Leistungshalbleiter.

Wie mit Bezug auf die vorherigen Ausführungsformen beschrieben, ist eine auf einer Leiterplatte befindliche Ansteuerlogik mit mindestens einem Leistungsmodul zur Ansteuerung desselben über eine Anschlussleitung elektrisch verbunden.

Wie oben in Zusammenhang mit den elektronischen Vorrichtungen 100, 200, 300, 400 und 500 beschrieben, sind diese Vorrichtungen in der Lage eine Verlustleistung in Form von Wärme der Leistungshalbleiter abzuführen, ohne dass eine Luftkonvektion notwendig wäre, was in Stromverteilern von Fahrzeugen aufgrund von geringer oder keiner Luftkonvektion besonders bevorzugt ist. Insbesondere wird dies durch eine gute thermische Anbindung eines Leistungshalbleiters an eine Stromschiene bewirkt.

Die Verwendung eines dazwischen liegenden Substrats führt zu einer hohen thermischen Zyklisierbarkeit von bis zu 170°C, wodurch die Lebensdauer der Vorrichtung und deren Zuverlässigkeit erhöht werden. Da zusätzliche Kühlkörper nicht notwendig sind, kann so auch der Bauraum und das Gewicht der Vorrichtung verringert werden.

Bei Verwendung von Keramik als Substrat können Standardlötprozesse zur Verbindung des Leistungshalbleiters und der Stromschiene mit der Leiterplatte verwendet werden. Somit lassen sich mehrere Vorteile erzielen, die insbesondere für die Verwendung von Leistungshalbleitern in der Fahrzeugelektronik oder anderen Einsatzgebieten mit eingeschränkter Luftkühlung von großer Bedeutung sind.

Aus der vorhergehenden Beschreibung entnimmt der Fachmann auch, dass verschiedenen Modifikationen und Variationen der dargestellten Vorrichtungen und des Verfahrens der Erfindung durchgeführt werden können, ohne den Umfang der Erfindung zu verlassen.

Ferner wurde die Erfindung mit Bezug auf bestimmte Beispiele beschrieben, die jedoch nur zum verbesserten Verständnis der Erfindung dienen sollen, und diese nicht einschränken sollen. Der Fachmann erkennt auch sofort, dass viele verschiedene Kombinationen der Elemente zur Ausführung der vorliegenden Erfindung verwendet werden können. Deshalb wird der wahre Umfang der Erfindung durch die folgenden Ansprüche gekennzeichnet.

## Patentansprüche

1. Elektronische Vorrichtung zum Schalten von Strömen, insbesondere in einem Fahrzeug, umfassend:
einen Leistungshalbleiter (6), der ansteuerbar ist zum Schalten zwischen mindestens zwei Zuständen;
ein Metall-Keramik-Substrat (5) mit zu dem Leistungshalbleiter (6) kompatiblen thermomechanischen Eigenschaften, wobei sich die Wärmeausdehnungskoeffizienten des Metall-Keramik-Substrats (5) und des Leistungshalbleiters (6) entsprechen, auf dem der Leistungshalbleiter (6) auf einer Seite angeordnet ist; und
eine Stromschiene (3), die auf der anderen Seite des Metall-Keramik-Substrats (5) angeordnet ist, zum Leiten eines Stroms, wobei
das Metall-Keramik-Substrat (5) und die Stromschiene (3) miteinander über eine wärmeleitende Schicht (10) gekoppelt sind, so dass eine wärmeleitende Verbindung bereitstellbar ist, und Wärme von dem Leistungshalbleiter (6) zur Stromschiene (3) abführbar ist.

2. Elektronische Vorrichtung nach Anspruch 1, wobei die wärmeleitende Schicht (10) einen thermisch leitenden Kleber, eine Wärmeleitpaste oder ein Silikon enthaltendes Pad umfasst.

3. Elektronische Vorrichtung nach einem der Ansprüche 1 bis 2, wobei die Stromschiene (3) mit dem Leistungshalbleiter (6) elektrisch verbunden ist.

4. Elektronische Vorrichtung nach einem der Ansprüche 1 bis 3, ferner umfassend eine Leiterplatte (1), wobei das Metall-Keramik-Substrat (5) und der Leistungshalbleiter (6) ein Leistungsmodul bilden, das mit der Leiterplatte (1) elektrisch verbunden ist.

5. Elektronische Vorrichtung nach Anspruch 4, wobei die Stromschiene (3) zwischen der Leiterplatte (1) und dem Metall-Keramik-Substrat (5) angeordnet ist.

6. Elektronische Vorrichtung nach Anspruch 4 oder 5, wobei die Leiterplatte (1) Anschlusskontakte (14, 16) aufweist zur elektrischen Verbindung mit dem Leistungsmodul über Anschlussleitungen.

7. Elektronische Vorrichtung nach Anspruch 6, ferner umfassend eine Messeinrichtung zum Messen des Spannungsabfalls über mindestens eine der Anschlussleitungen.

8. Elektronische Vorrichtung nach einem der Ansprüche 4 bis 7, wobei die Stromschiene (3) über Lötfahnen mit der Leiterplatte (1) elektrisch verbunden ist.

9. Elektronische Vorrichtung nach einem der Ansprüche l bis 8, ferner umfassend eine weitere Stromschiene (9, 30), wobei die weitere Stromschiene (9) neben der Stromschiene (3) auf der anderen Seite des Metall-Keramik-Substrats (5) angeordnet ist.

10. Elektronische Vorrichtung nach einem der Ansprüche l bis 8, ferner umfassend eine weitere Stromschiene (9, 30), wobei die weitere Stromschiene (30) auf der einen Seite des Metall-Keramik-Substrats (5) angeordnet ist, und das Metall-Keramik-Substrat (5) und die weitere Stromschiene (30) miteinander über eine wärmeleitende Schicht (10) gekoppelt sind, so dass eine wärmeleitende Verbindung bereitstellbar ist, und Wärme von dem Leistungshalbleiter (6) zur weiteren Stromschiene (30) abführbar ist.

11. Elektronische Vorrichtung nach Anspruch 9 oder 10, wobei die Stromschiene (3) und die weitere Stromschiene (9) elektrisch verbunden sind, und die Stromführung derart ausgebildet ist, dass eine der Stromschienen als stromzuführende Stromschiene dient und die andere als stromabführende Stromschiene dient.

12. Elektronische Vorrichtung nach einem der Ansprüche 9 bis 11, wobei auf jeder der Stromschienen (3, 9) ein Metall-Keramik-Substrat (5) mit mindestens einem Leistungshalbleiter (6) angeordnet ist.

13. Elektronische Vorrichtung nach einem der Ansprüche 4 bis 12, ferner umfassend eine auf der Leiterplatte (l) angeordnete Ansteuerlogik (12).

## Claims

1. Electronic device for switching currents, in particular in a vehicle, comprising:
a power semiconductor (6), which is drivable for switching between at least two states;
a metal-ceramic substrate (5) having thermomechanical properties compatible with the power semiconductor (6), wherein the coefficients of thermal expansion of the metal-ceramic substrate (5) and of the power semiconductor (6) correspond to one another, on which metal-ceramic substrate the power semiconductor (6) is arranged on one side; and
a busbar (3), arranged on the other side of the metal-ceramic substrate (5), for conducting a current, wherein
the metal-ceramic substrate (5) and the busbar (3) are coupled to one another by way of a heat-conducting layer (10), such that a heat-conducting connection is providable, and heat is dissipatable from the power semiconductor (6) to the busbar (3) .

2. Electronic device according to Claim 1, wherein the heat-conducting layer (10) comprises a thermally conductive adhesive, a thermally conductive paste or a pad containing silicone.

3. Electronic device according to either of Claims 1 and 2, wherein the busbar (3) is electrically connected to the power semiconductor (6).

4. Electronic device according to any of Claims 1 to 3, furthermore comprising a printed circuit board (1), wherein the metal-ceramic substrate (5) and the power semiconductor (6) form a power module that is electrically connected to the printed circuit board (1).

5. Electronic device according to Claim 4, wherein the busbar (3) is arranged between the printed circuit board (1) and the metal-ceramic substrate (5) .

6. Electronic device according to Claim 4 or 5, wherein the printed circuit board (1) has connection contacts (14, 16) for electrical connection to the power module via connection lines.

7. Electronic device according to Claim 6, furthermore comprising a measuring unit for measuring the voltage drop across at least one of the connection lines.

8. Electronic device according to any of Claims 4 to 7, wherein the busbar (3) is electrically connected to the printed circuit board (1) by way of soldering lugs.

9. Electronic device according to any of Claims 1 to 8, furthermore comprising a further busbar (9, 30), wherein the further busbar (9) is arranged next to the busbar (3) on the other side of the metal-ceramic substrate (5).

10. Electronic device according to any of Claims 1 to 8, furthermore comprising a further busbar (9, 30), wherein the further busbar (30) is arranged on said one side of the metal-ceramic substrate (5), and the metal-ceramic substrate (5) and the further busbar (30) are coupled to one another by way of a heat-conducting layer (10), such that a heat-conducting connection is providable, and heat is dissipatable from the power semiconductor (6) to the further busbar (30).

11. Electronic device according to Claim 9 or 10, wherein the busbar (3) and the further busbar (9) are electrically connected, and the current carrying is embodied in such a way that one of the busbars serves as a current-feeding busbar and the other serves as a current-discharging busbar.

12. Electronic device according to any of Claims 9 to 11, wherein a metal-ceramic substrate (5) with at least one power semiconductor (6) is arranged on each of the busbars (3 ,9).

13. Electronic device according to any of Claims 4 to 12, furthermore comprising a drive logic (12) arranged on the printed circuit board (1).

## Revendications

1. Dispositif électronique pour commuter des courants, notamment dans un véhicule, comprenant :
un semiconducteur de puissance (6) qui peut être amorcé pour commuter entre au moins deux états ;
un substrat en cermet (5) ayant des propriétés thermomécaniques compatibles avec le semiconducteur de puissance (6), les coefficients de dilatation thermique du substrat en cermet (5) et du semiconducteur de puissance (6) étant correspondants, sur lequel le semiconducteur de puissance (6) est disposé sur un côté ; et
une barre-bus (3), qui est disposée sur l'autre côté du substrat en cermet (5) et destinée à conduire un courant,
le substrat en cermet (5) et la barre-bus (3) étant couplés l'un à l'autre par le biais d'une couche conductrice de chaleur (10), de sorte qu'une liaison conductrice de chaleur peut être établie et que la chaleur du semiconducteur de puissance (6) peut être dissipée vers la barre-bus (3).

2. Dispositif électronique selon la revendication 1, la couche conductrice de chaleur (10) comprenant une colle thermoconductrice, une pâte conductrice de chaleur ou une pastille contenant du silicone.

3. Dispositif électronique selon l'une des revendications 1 et 2, la barre-bus (3) étant reliée électriquement au semiconducteur de puissance (6).

4. Dispositif électronique selon l'une des revendications 1 à 3, comprenant en outre un circuit imprimé (1), le substrat en cermet (5) et le semiconducteur de puissance (6) formant un module de puissance qui est relié électriquement au circuit imprimé (1) .

5. Dispositif électronique selon la revendication 4, la barre-bus (3) étant disposée entre le circuit imprimé (1) et le substrat en cermet (5).

6. Dispositif électronique selon la revendication 4 ou 5, le circuit imprimé (1) possédant des contacts de raccordement (14, 16) destinés à la liaison électrique avec le module de puissance par le biais de lignes de raccordement.

7. Dispositif électronique selon la revendication 6, comprenant en outre un instrument de mesure destiné à mesurer la chute de tension aux bornes d'au moins l'une des lignes de raccordement.

8. Dispositif électronique selon l'une des revendications 4 à 7, la barre-bus (3) étant reliée électriquement au circuit imprimé (1) par le biais de lames à braser.

9. Dispositif électronique selon l'une des revendications 1 à 8, comprenant en outre une barre-bus supplémentaire (9, 30), la barre-bus supplémentaire (9) étant disposée à côté de la barre-bus (3) sur l'autre côté du substrat en cermet (5).

10. Dispositif électronique selon l'une des revendications 1 à 8, comprenant en outre une barre-bus supplémentaire (9, 30), la barre-bus supplémentaire (30) étant disposée sur un côté du substrat en cermet (5), et le substrat en cermet (5) et la barre-bus supplémentaire (30) étant couplés l'un à l'autre par le biais d'une couche conductrice de chaleur (10), de sorte qu'une liaison conductrice de chaleur peut être établie et que la chaleur du semiconducteur de puissance (6) peut être dissipée vers la barre-bus supplémentaire (30).

11. Dispositif électronique selon la revendication 9 ou 10, la barre-bus (3) et la barre-bus supplémentaire (9) étant reliées électriquement et le passage du courant étant configuré de telle sorte que l'une des barres-bus sert de barre-bus d'arrivée de courant et l'autre de barre-bus de départ de courant.

12. Dispositif électronique selon l'une des revendications 9 à 11, un substrat en cermet (5) comprenant au moins un semiconducteur de puissance (6) étant disposé sur chacune des barres-bus (3, 9).

13. Dispositif électronique selon l'une des revendications 4 à 12, comprenant en outre une logique d'amorçage (12) disposée sur le circuit imprimé (1).
